# EUROPEAN PATENT APPLICATION

(11) **EP 4 568 436 A1**
(43) Date of publication of application: **11.06.2025**
(21) Application number: 24171940.0
(22) Date of filing: 23.04.2024
(51) Int. Cl.: H05K 7/20, F28D 21/00

(54) **POWER CONVERSION DEVICE**

(30) Priority: 08.12.2023 CN 202323368920 U
(71) Applicant: Sungrow Power Supply Co., Ltd., Hefei, Anhui 230088 (CN)
(72) Inventor: ZHANG, Fan, Hefei, Anhui (CN); SU, Wenjie, Hefei, Anhui (CN); LIU, Yongjin, Hefei, Anhui (CN); WANG, Rui, Hefei, Anhui (CN)
(74) Representative: Zacco Norway AS

(57) **Abstract**

A power conversion device is provided, including a body (10), a heat dissipation portion (20), and a shield sheet (30). The heat dissipation portion (20) includes multiple fins (21, 22) arranged spaced apart on the body (10), each fin (21, 22) includes a connection end and a free end being opposite to each other, and the fin (21, 22) is fixedly connected to the body (10) through the connection end. The shield sheet (30) is provided at a side of the heat dissipation portion away from the body (10), where the shield sheet (30) shields a part of or all of free ends of the multiple fins (21, 22). With the technical solutions of the present application, a problem in the prior art that human hands are apt to be scratched by heat dissipation fins can be solved.

## Description

### FIELD

The present application relates to the technical field of electrical devices, and in particular to a power conversion device.

### BACKGROUND

At present, a power conversion device, as an important part of a photovoltaic system, generates a lot of heat during operation. To dissipate the heat, a heat dissipation structure is usually mounted to the power conversion device. In the prior art, the heat dissipation structure is generally a heat dissipation fin structure. To satisfy the requirement for a mounting space of the power conversion device, the power conversion device is generally provided with a relatively small size, and the heat dissipation fins are designed to be relatively small correspondingly. During mounting of the power conversion device, an installation worker has to pick up the power conversion device for mounting and fixation, and the installation worker is apt to be scratched by the relatively small heat dissipation fin structure.

### SUMMARY

A power conversion device is provided in the present application, to solve the problem in the prior art that hands of the installation worker are apt to be scratched by heat dissipation fins.

A power conversion device is provided in the present application, including:
a body;
a heat dissipation portion, where the heat dissipation portion is provided with multiple fins arranged spaced apart on the body, each of the multiple fins includes a connection end and a free end opposite to each other, and the fin is fixedly connected to the body through the connection end; and
a shield sheet, being provided at a side of the heat dissipation portion away from the body, where the shield sheet shields a part of or all of free ends of the multiple fins.

In an embodiment, the multiple fins includes at least one heat dissipation fin and at least one supporting fin, and the shield sheet is arranged at a free end of the at least one supporting fin.

In an embodiment, the shield sheet is connected to a free end of one of the at least one supporting fin, and the shield sheet is located at one side or two sides of the one of the at least one supporting fin.

In an embodiment, the heat dissipation portion includes a first end portion and a second end portion arranged opposite to each other in a direction along which the multiple fins are distributed spaced apart; the at least one supporting fin is located at the first end portion and/or the second end portion; and/or the at least one supporting fin is located between the first end portion and the second end portion.

In an embodiment, multiple supporting fins are provided, the shield sheet is connected to the multiple supporting fins, and at least one shield region is formed by connection between the shield sheet and the multiple supporting fins.

In an embodiment, the multiple fins further includes at least one heat dissipation fin, the at least one heat dissipation fin and the multiple supporting fins are arranged spaced apart, and at least one of the at least one heat dissipation fin is located in the at least one shield region.

In an embodiment, the multiple fins further includes at least one heat dissipation fin, and a gap is provided between a free end of the at least one heat dissipation fin and the shield sheet.

In an embodiment, a pierced structure is provided at the shield sheet, and the pierced structure is configured to avoid direct contact between a human hand and the multiple fins.

In an embodiment, in a direction along which the multiple fins are distributed, a free end of a head end fin and a free end of a tail end fin extend in opposite directions away from each other, to respectively form a handle structure; and where the head end fin and the tail end fin are two outermost fins located at two ends of the heat dissipation portion respectively.

In an embodiment, the handle structure protrudes with respect to free ends of the multiple fins except the head end fin and the tail end fin.

With the technical solutions according to the present application, the shield sheet is provided at the free ends of the fins away from the body, which prevents human hands from directly touching the fins, so as to avoid the mounting worker from being scratched by the fins during mounting of the power conversion device, and thereby reducing an accident rate. Moreover, the shield sheet provides protection to the fins, which prevents the fins from being damaged or falling off under an impact, and thereby increasing durability of the heat dissipation portion.

### BRIEF DESCRIPTION OF THE DRAWINGS

The accompanying drawings constituting a part of the present application are used for further understanding of the present application. Exemplary embodiments of the present application and description thereof are used for illustrating the present application, and are not intended to form an improper limit to the present application.
FIG. 1 is a schematic view showing the structure of a power conversion device according to the present application;
FIG. 2 is a side view showing a power conversion device according to a first embodiment of the present application;
FIG. 3 is a side view showing a power conversion device according to a second embodiment of the present application;
FIG. 4 is a side view showing a power conversion device according to a third embodiment of the present application;
FIG. 5 is a side view showing a power conversion device according to a fourth embodiment of the present application;
FIG. 6 is a side view showing a power conversion device according to a fifth embodiment of the present application;
FIG. 7 is a side view showing a power conversion device according to a sixth embodiment of the present application;
FIG. 8 is a side view showing a power conversion device according to a seventh embodiment of the present application;
FIG. 9 is a side view showing a power conversion device according to an eighth embodiment of the present application;
FIG. 10 is a side view showing a power conversion device according to a ninth embodiment of the present application;
FIG. 11 is a side view showing a power conversion device according to a tenth embodiment of the present application;
FIG. 12 is a side view showing a power conversion device according to an eleventh embodiment of the present application;
FIG. 13 is a side view showing a power conversion device according to a twelfth embodiment of the present application;
FIG. 14 is a side view showing a power conversion device according to a thirteenth embodiment of the present application;
FIG. 15 is a side view showing a power conversion device according to a fourteenth embodiment of the present application;
FIG. 16 is a side view showing a power conversion device according to a fifteenth embodiment of the present application;
FIG. 17 is a side view showing a power conversion device according to a sixteenth embodiment of the present application;
FIG. 18 is a side view showing a power conversion device according to a seventeenth embodiment of the present application;
FIG. 19 is a side view showing a power conversion device according to an eighteenth embodiment of the present application; and
FIG. 20 is a schematic view showing a power conversion device according to the present application being mounted.

Reference numerals are as follows.

| | | | |
|---|---|---|---|
| 10 | body, | 20 | heat dissipation portion, |
| 21 | heat dissipation fin, | 22 | supporting fin, |
| 30 | shield sheet, | 40 | handle structure. |

### DETAILED DESCRIPTION OF THE EMBODIMENTS

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. The following description of at least one exemplary embodiment is merely illustrative and is not intended to limit the present application, and use thereof. All the other embodiments obtained by those skilled in the art based on the embodiments in the present application without any creative work belong to the scope of protection of the present application.

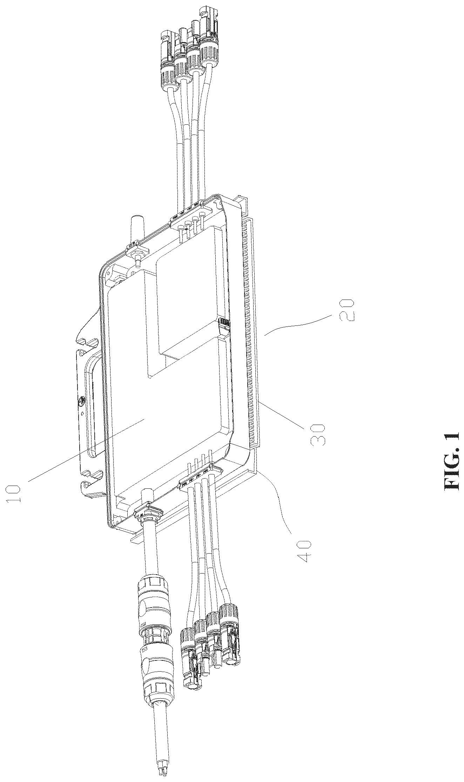

As shown in FIG. 1, a power conversion device is provided according to the embodiments of the present application, including a body 10, a heat dissipation portion 20 and a shield sheet 30. The heat dissipation portion 20 includes multiple fins arranged spaced apart on the body 10. Each of the multiple fins includes a connection end and a free end arranged opposite to each other, and the fin is fixedly connected to the body 10 through the connection end. The shield sheet 30 is provided at a side of the heat dissipation portion 20 away from the body 10, and the shield sheet 30 shields a part of or all of free ends of the multiple fins.

It may be appreciated that, the power conversion device includes, but is not limited to, an inverter, a converter, a rectifier or a transformer.

With the technical solutions according to the present application, the shield sheet 30 is provided at the free ends of the fins away from the body 10, which prevents human hands from directly touching the fins, so as to avoid a mounting worker from being scratched by the fins during mounting of the power conversion device, and thereby reducing an accident rate. Moreover, the shield sheet 30 provides protection to the fins, which prevents the fins from being damaged or falling off under an impact, and thereby increasing durability of the heat dissipation portion 20.

Specifically, the multiple fins includes at least one heat dissipation fin 21 and at least one supporting fin 22, and the shield sheet 30 is arranged at a free end of the at least one supporting fin 22. With the above arrangements, the supporting fin 22 provides support to the shield sheet 30, which prevents the shield sheet 30 from damaging the heat dissipation fin 21 under an impact, and improves the overall structural stability of the heat dissipation portion 20.

Specifically in this application, the shield sheet 30 may shield all of the fins, or may shield some the fins, or may shield a portion in a length direction of some the fins, which is not specifically limited herein. For instance, one of the fins is taken as an example, where only a portion in the length direction of the fin, which can be easily touched by the hand, is shielded, as long as protection is provided while not affecting the heat exchange performance of the fin a lot.

In the present application, the shield sheet 30 is connected to a free end of one supporting fin 22, and the shield sheet 30 is located at one side or two sides of the one supporting fin 22. With the above arrangements, one supporting fin 22 is enough to provide support to the shield sheet 30 to ensure shielding performance of the shield sheet 30, so as to prevent human hands from being scratched by the free end of the heat dissipation fin 21.

Specifically, the heat dissipation portion 20 includes a first end portion and a second end portion arranged opposite to each other in a direction along which the multiple fins are distributed spaced apart, and the supporting fin 22 is located at the first end portion and/or the second end portion; and/or the supporting fin 22 is located between the first end portion and the second end portion.

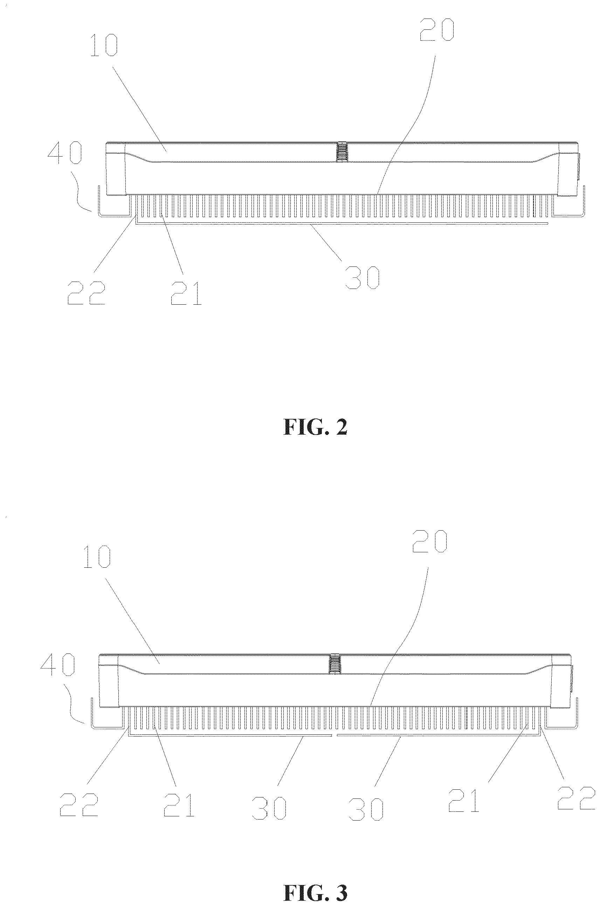

Referring to FIG. 2, in a first embodiment of the present application, one supporting fin 22 is provided, and the supporting fin 22 is arranged at the first end portion of the heat dissipation portion 20. A shield sheet 30 is arranged at a free end of the supporting fin 22 and extends towards the second end portion, so as to perform shielding. Further, regarding an extension manner of the shield sheet 30 towards the second end portion, the shield sheet 30 may shield a portion of the heat dissipation portion 20 started from the first end portion, to prevent hands from being scratched on the first end portion; alternatively, the shield sheet 30 may shield the whole heat dissipation portion 20 started from the first end portion, to prevent hands from being scratched on the first end portion or the second end portion.

Referring to FIG. 3, in a second embodiment of the present application, two supporting fins 22 are provided, and the two supporting fins 22 are arranged at the first end portion and the second end portion of the heat dissipation portion 20 respectively. Two shield sheets 30 are provided at free ends of the two supporting fins 22 respectively, where one of the two shield sheets 30, being connected to the supporting fin 22 located at the first end portion, extends towards the second end portion, and the other of the two shield sheets 30, being connected to the supporting fin 22 located at the second end portion, extends towards the first end portion. In this way, a moment arm applied on the corresponding supporting fin 22 by the shield sheet 30 is reduced, and a torque applied on the corresponding supporting fin 22 by the shield sheet 30 is decreased, which prevents the supporting fin 22 from being bent, and thereby structural stability of the supporting fin 22 is increased.

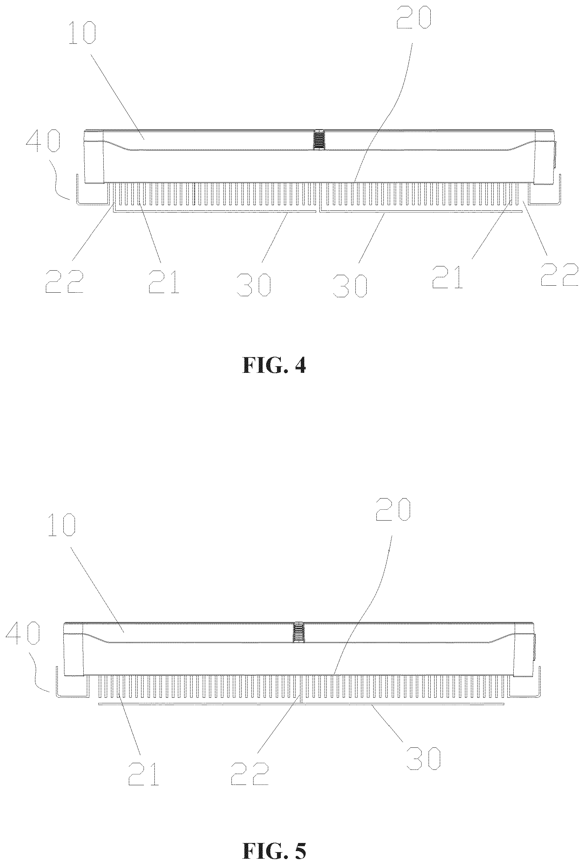

Referring to FIG. 4, in a third embodiment of the present application, multiple supporting fins 22 are provided, one of the multiple supporting fins 22 is arranged at the first end portion of the heat dissipation portion 20, and another one of the multiple supporting fins 22 is arranged between the first end portion and the second end portion. Shield sheets 30 respectively connected to the two of the multiple supporting fins 22 both extend towards the second end portion.

Referring to FIG. 5, in a fourth embodiment of the present application, one supporting fin 22 is provided, and the supporting fin 22 is arranged between the first end portion and the second end portion of the heat dissipation portion 20. A shield sheet 30 is arranged at a free end of the supporting fin 22 and is located at both sides of the supporting fin 22, i.e. the shield sheet 30 extends towards both the first end portion and the second end portion, which improves the supporting performance of the supporting fin 22 to the shield sheet 30.

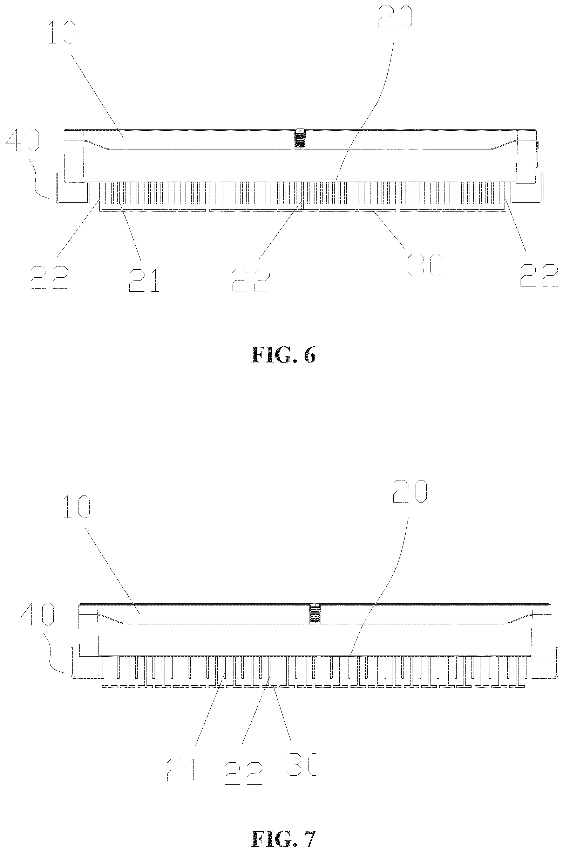

Referring to FIG. 6, in a fifth embodiment of the present application, three supporting fins 22 are provided, and one of the three supporting fins 22 is arranged between the first end portion and the second end portion of the heat dissipation portion 20. One shield sheet 30 is arranged at a free end of the one of the three supporting fins 22, and is located at both sides of the one of the three supporting fins 22, i.e. the one shield sheet 30 extends toward both the first end portion and the second end portion. The other two of the three supporting fins 22 are arranged at the first end portion and the second end portion of the heat dissipation portion 20 respectively; where another shield sheet 30, connected to the supporting fin 22 located at the first end portion, extends toward the second end portion; and the yet another shield sheet 30, connected to the supporting fin 22 located at the second end portion, extends toward the first end portion.

Referring to FIG. 7, in a sixth embodiment of the present application, multiple supporting fins 22 and multiple shield sheets 30 are provided in one-to-one correspondence. Each pair of the shield sheet 30 and the corresponding supporting fin 22 is substantially of a T-shaped structure. The multiple supporting fins 22 are arranged at the first end portion, the second end portion, and between the first end portion and the second end portion. A heat dissipation fin 21 is provided between two adjacent supporting fins 22. In a technical solution, multiple heat dissipation fins 21 are provided, and two or more of the multiple heat dissipation fins 21 are arranged between adjacent two supporting fins 22. In another technical solution, multiple heat dissipation fins 21 are provided, and the multiple heat dissipation fins 21 and the multiple supporting fins 22 are alternatively arranged. With the above arrangements, each of the supporting fins 22 is provided with a corresponding shield sheet 30, and the multiple shield sheets 30 increase a contact surface area between the fins and air as much as possible on the premise that the protection effect is realized, thereby improving the heat dissipation performance of the heat dissipation portion 20.

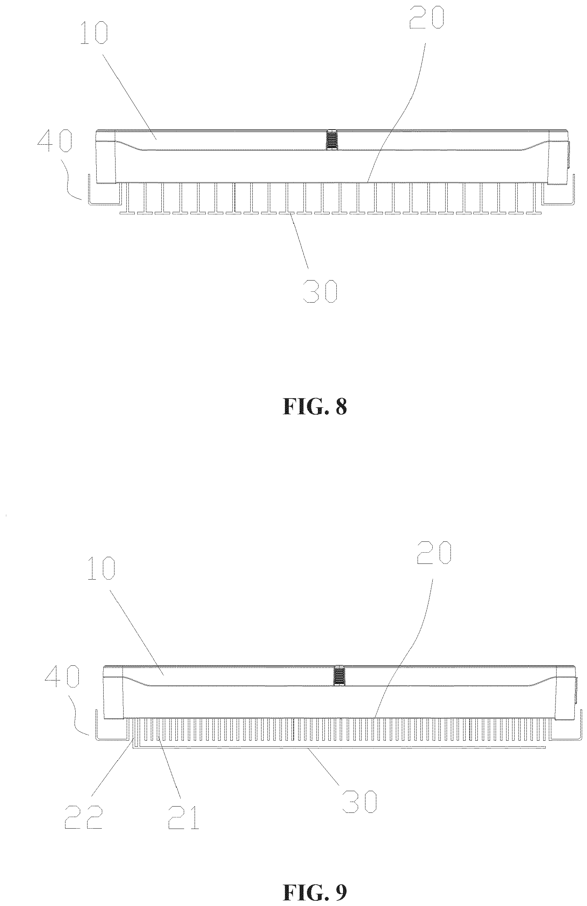

Referring to FIG. 8, in a seventh embodiment of the present application, the multiple fins are embodied as supporting fins 22, that is, the fins in the present embodiment include supporting fins 22 only. Multiple shield sheets 30 are provided in one-to-one correspondence with multiple supporting fins 22. Differing from the sixth embodiment, the shield sheets 30 in the present embodiment are integrally formed with the supporting fins 22. The shield sheets 30 prevent human hands from touching the fins, and the fins directly support the shield sheets 30, which reduces processing difficulty of the heat dissipation portion 20.

In some specific embodiments of the present application, a shield sheet 30 is connected to multiple supporting fins 22, and at least one shield region is formed by connection between the shield sheet 30 and the multiple supporting fins 22. Herein, the shield region refers to a projection region of the shield sheet 30 on the body of the power conversion device. With the above arrangements, the multiple supporting fins 22 connected to the shield sheet 30 provide more stable support to the shield sheet 30, which increases stability of connection between the shield sheet 30 and the fins, and prevents the shield sheet 30 from being deformed or falling off.

Referring to FIG. 9, in an eighth embodiment of the present application, two supporting fins 22 are provided, where one of the two supporting fins 22 is arranged at the first end portion of the heat dissipation portion 20, and the other one of the two supporting fins 22 is adjacent to the one of the two supporting fins 22 arranged at the first end portion. A shield sheet 30 is arranged at free ends of the two supporting fins 22, and extends towards the second end portion to perform shielding. By providing two supporting fins 22, connection strength of the shield sheet 30 is further improved, to prevent the shield sheet 30 from falling off.

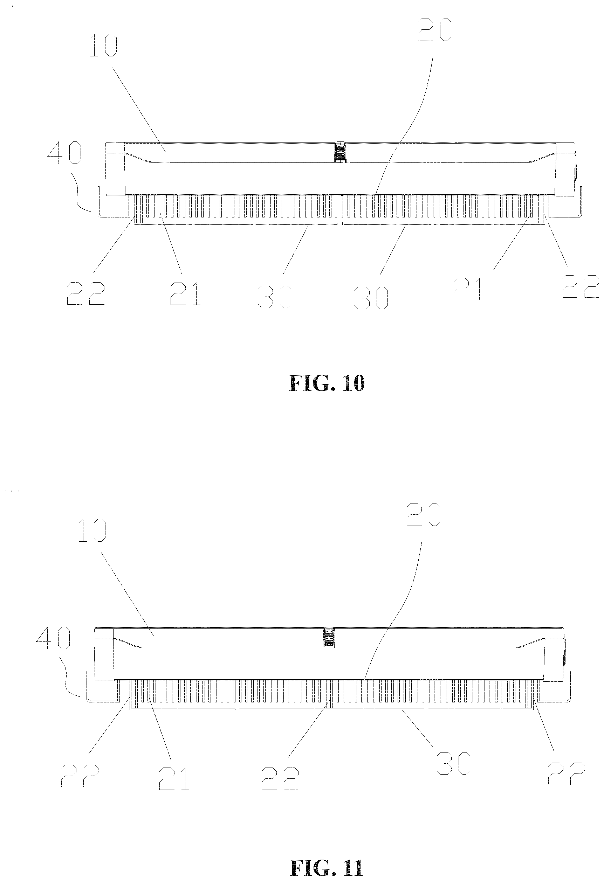

Referring to FIG. 10, in a ninth embodiment of the present application, two shield sheets 30 are provided, and each of the two shield sheets 30 is connected to free ends of two supporting fins 22. In the present embodiment, the two supporting fins 22 connected to the same shield sheet 30 form a supporting group, and the two supporting groups are arranged at two ends of the heat dissipation portion 20 respectively. With the above arrangements, the support to the shield sheets 30 by the supporting fins 22 is further improved.

Referring to FIG. 11, in a tenth embodiment of the present application, three shield sheets 30 are provided, and each of the three shield sheets 30 is connected to two supporting fins 22. In the present embodiment, the two supporting fins 22 connected to the same shield sheet 30 form a supporting group. Two of the three supporting groups are arranged at two ends of the heat dissipation portion 20 respectively, and the other one of the three supporting groups is arranged between the two supporting groups located at the two ends of the heat dissipation portion 20. In this way, the support to the shield sheets 30 by the supporting fins 22 is further improved. Meanwhile, the shield sheets 30 each has a smaller size, which reduces a deformation risk of the shield sheets 30.

In other technical solutions of the eighth to the tenth embodiments, there may be no heat dissipation fins 21 in the shield region. In other specific embodiments of the present application, at least one heat dissipation fin 21 is provided in at least one shield region. It is not specifically limited herein whether the shield region is provided with the heat dissipation fin 21 or not, as long as the shielding of the heat dissipation fin 21 is performed, and processing of the heat dissipation portion 20 is facilitated.

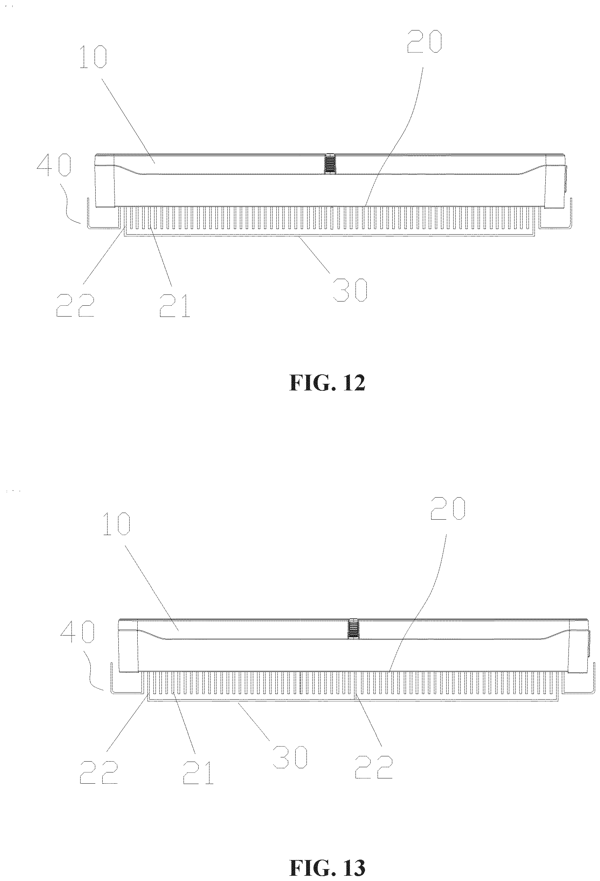

Referring to FIG. 12, in an eleventh embodiment of the present application, the multiple fins includes two supporting fins 22, and the two supporting fins 22 are arranged spaced apart from each other. Multiple heat dissipation fins 21 are provided in a shield region formed between the two supporting fins 22, and a shield sheet 30 is arranged on the two supporting fins 22.

Referring to FIG. 13, in a twelfth embodiment of the present application, the multiple fins includes multiple supporting fins 22, and the multiple supporting fins 22 are arranged spaced apart from each other. Multiple heat dissipation fins 21 are provided between each two adjacent supporting fins 22, and a shield sheet 30 is arranged on the multiple supporting fins 22. With the above arrangements, the supporting fin 22 arranged in the middle provides further support to the shield sheet 30 to some extent, which improves the structural reliability of the shield sheet 30.

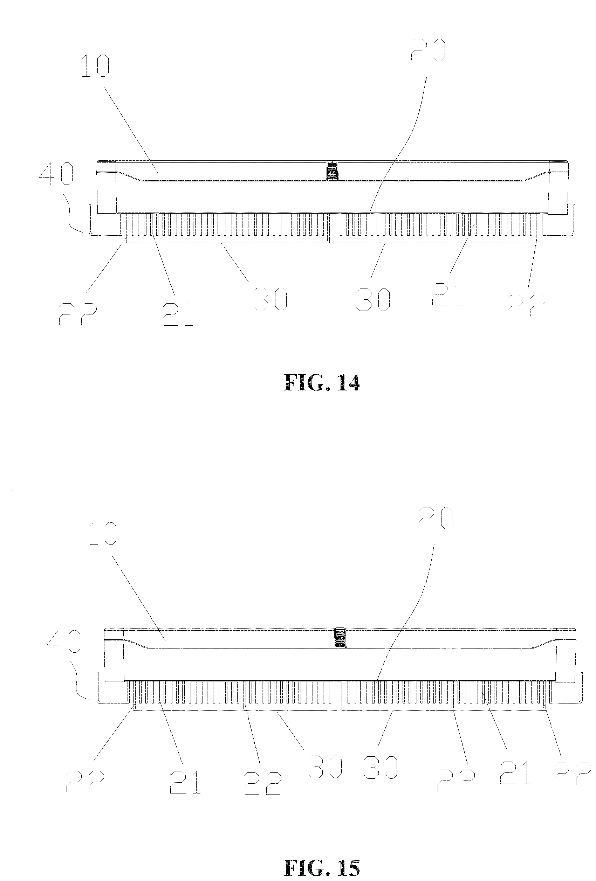

Referring to FIG. 14, in a thirteenth embodiment of the present application, the heat dissipation portion 20 includes multiple first supporting groups, and each of the multiple first supporting groups includes two supporting fins 22 and a shield sheet 30 arranged on the two supporting fins 22. The multiple first supporting groups are distributed on the body 10 spaced apart from each other, and multiple heat dissipation fins 21 are provided between the two supporting fins 22 of each of the multiple first supporting groups. With the above arrangements, a width of the shield sheet 30 of each of the first supporting groups is decreased on the premise that an area shielded by the shield sheet 30 is not affected, which reduces a deflection risk of the shield sheet 30, improves structural performance of the shield sheet 30, and further improves the protection ability of the shield sheet 30 to the fins.

Referring to FIG. 15, in a fourteenth embodiment of the present application, the heat dissipation portion 20 includes multiple second supporting groups, and each of the multiple second supporting groups includes at least three supporting fins 22 and a shield sheet 30 arranged on the at least three supporting fins 22. The multiple second supporting groups are distributed on the body 10 spaced apart from each other, and one or multiple heat dissipation fins 21 are provided between two adjacent supporting fins 22 of each of the multiple second supporting groups. With the above arrangements, each shield sheet 30 is connected to multiple supporting fins 22, which further improves structural strength of the shield sheet 30, prevents the shield sheet 30 from being bent or damaged under an impact, and ensures the protection performance of the shield sheet 30 to the fins.

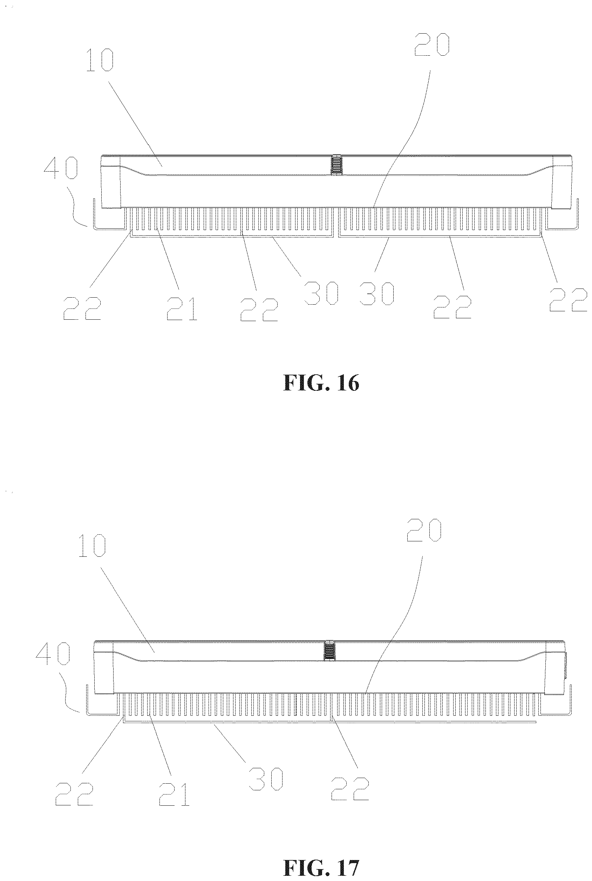

Referring to FIG. 16, in a fifteenth embodiment of the present application, the heat dissipation portion 20 includes at least one third supporting group and at least one fourth supporting group. The third supporting group includes two supporting fins 22 and a shield sheet 30 arranged on the two supporting fins 22, and multiple heat dissipation fins 21 are provided between the two supporting fins 22 of the third supporting group. The fourth supporting group includes at least three supporting fins 22 and a shield sheet 30 arranged on the at least three supporting fins 22, and multiple heat dissipation fins 21 are provided between each two adjacent supporting fins 22 of the fourth supporting group. With the above arrangements, the at least one third supporting group and the at least one fourth supporting group support the shield sheets 30 at the same time, to improve the supporting performance to the shield sheet 30.

Referring to FIG. 17, in a sixteenth embodiment of the present application, the heat dissipation portion 20 includes two supporting fins 22, where one of the two supporting fins 22 is arranged at one end of the heat dissipation portion 20, and the other one of the two supporting fins 22 is arranged between both ends of the heat dissipation portion. Multiple heat dissipation fins 21 are provided in a shielded space formed by the two supporting fins 22. In this application, both ends refer to two ends of the heat dissipation portion in the direction along which the heat dissipation fins are distributed.

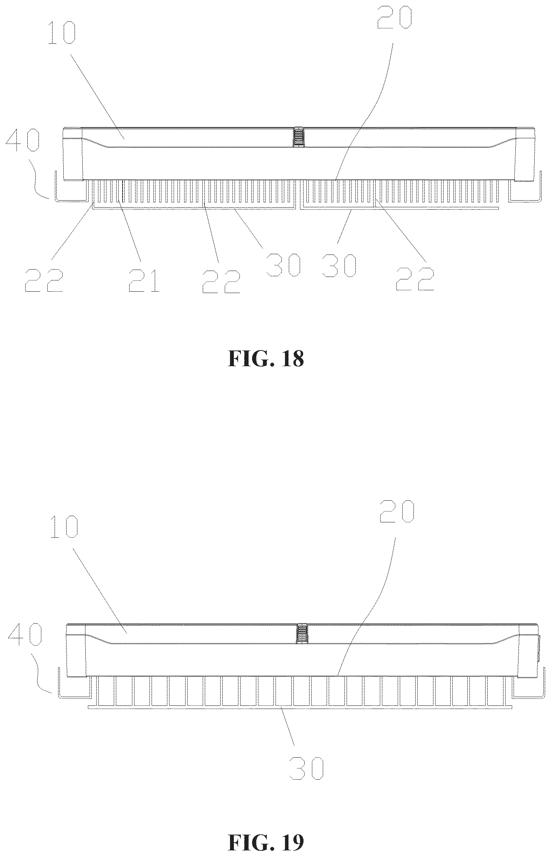

Referring to FIG. 18, in a seventeenth embodiment of the present application, the heat dissipation portion 20 includes at least one fifth supporting group and at least one sixth supporting group. The fifth supporting group includes at least two supporting fins 22 and a shield sheet 30 arranged on the at least two supporting fins 22, and at least two of the at least two supporting fins 22 are arranged at two sides of the shield sheet 30 opposite to each other in a direction along which the multiple fins are distributed. Multiple heat dissipation fins 21 are provided between two adjacent supporting fins 22 of the fifth supporting group. The sixth supporting group includes at least two supporting fins 22, where at least one of the at least two supporting fins 22 is arranged at one of two sides of a shield sheet 30 opposite to each other in a direction along which the multiple fins are distributed, and another one of the at least two supporting fins 22 is arranged between the two sides of the shield sheet 30 opposite to each other in the direction along which the multiple fins are distributed.

Referring to FIG. 19, in an eighteenth embodiment of the present application, one shield sheet 30 is provided, and free ends of the multiple fins are all connected to the shield sheet 30. In this way, the shield sheet 30 increases a contact surface area between the heat dissipation portion 20 and air as much as possible while providing the protection, thereby improving the heat dissipation performance of the heat dissipation portion 20.

In the embodiments of the present application, in the direction along which the multiple fins are distributed spaced apart, the shield sheet 30 may extend towards any one of both sides, or may extend towards both sides at the same time. The shield sheet 30 shields all of or a part of the heat dissipation fins 21, which is not limited in the present application, as long as the heat dissipation fin 21 is shielded. Further, in the present application, the specific position where the supporting fin 22 is arranged is not limited, as long as the shield sheet 30 is supported.

In some embodiments of the present application, there is a gap between a free end of the heat dissipation fin 21 and the shield sheet 30. That is, a distance between a free end and a connection end of the supporting fin 22 is larger than a distance between a free end and a connection end of the heat dissipation fin 21. With the above arrangements, the gap between the free end of the heat dissipation fin 21 and the shield sheet 30 forms an air flow channel. In a case that the power conversion device is mounted in a relatively narrow space, air flowing in the air flow channel can take away heat generated by the power conversion device during operation, which prevents the situation that the heat may not able to be dissipated, and thereby ensuring normal operation of the power conversion device.

In other embodiments of the present application, the distance between the free end and the connection end of the supporting fin 22 is equal to the distance between the free end and the connection end of the heat dissipation fin 21. In this way, the shield sheet 30 can be supported by the heat dissipation fin 21 as well, which further prevents the shield sheet 30 from being deformed.

Further, the shield sheet 30 and the supporting fin 22 may be integrally formed, to improve the connection stability between the shield sheet 30 and the supporting fin 22. Further, the shield sheet 30, the heat dissipation fin 21 and the supporting fin 22 may be integrally formed, to further improve the connection stability between the shield sheet and the supporting fin 22.

Specifically, the shield sheet 30 may be made of the same material as the fins. In this way, the shield sheet 30 connected to the fins can dissipate heat as well, which increases a contact surface area between the fins and the environment, thereby further improving the heat dissipation performance of the heat dissipation portion 20. The heat dissipation fin 21 and the supporting fin 22 may be made of the same material, and have almost the same function, with the only difference that the supporting fin 22 has a larger height. The heat dissipation fin 21 and the supporting fin 22 may be made of different materials, and the supporting fin 22 only provides protection to the heat dissipation fin 21, which is not specifically limited in the present application.

Further, in a case that multiple supporting fins 22 are provided in the present application, intervals of the multiple supporting fins 22 may be equal to each other to facilitate processing of the shield sheet 30, or may be unequal to each other to facilitate flexible design of the heat dissipation portion 20, which is not limited in the present application.

Further, a pierced structure is provided on the shield sheet 30, and human hands are not able to directly touch the fins through the pierced structure. With the pierced structure being provided on the shield sheet 30, convective heat exchange between the fins the air will not be hindered by the shield sheet 30, and the heat dissipation performance of the heat dissipation portion 20 is ensured; moreover, the overall weight of the shield sheet 30 can be reduced, which further reduces the overall weight of the power conversion device.

Specifically, the pierced structure may be embodied as a through hole, and the shape of the through hole is not limited in the present application, as long as the heat dissipation performance of the pierced structure is ensured.

Further, the pierced structure is configured to have a size such that a finger of the human hand cannot pass through. For example, the pierced structure is configured to have a diameter smaller than a diameter of the little finger or the index finger of the human hand.

In the present application, referring to FIGS. 2 to 19, in the direction along which the multiple fins are distributed, both ends of the heat dissipation portion 20 are referred as a head end and a tail end respectively, and a head end fin and a tail end fin are two outermost fins located at the head end and the tail end of the heat dissipation portion respectively. A free end of the head end fin and a free end of the tail end fin extend in opposite directions away from each other, i.e. the free end of the fin at the head end extends toward the tail end in the distribution direction of the multiple fins, and the free end of the fin at the tail end extends toward the head end in the distribution direction of the multiple fins, to form a handle structure 40. With the above arrangements, during transportation and mounting of the power conversion device, the mounting worker can lift and carry the power conversion device by grasping the handle structure 40 with a hand, which facilitates mounting of the power conversion device. Meanwhile, the free end of the head end fin and the free end of the tail end fin extend in the opposite directions away from each other, such that hands of the mounting worker can avoid the fins when carrying the power conversion device, thereby preventing the hands of the mounting worker from being scratched by the fins. Moreover, by providing the fins in the extension manner, surface areas of the head end fin and the tail end fin are increased, and the contact surface area between the heat dissipation portion 20 and air is further increased, thereby improving the heat dissipation performance of the heat dissipation portion 20.

Specifically, the free end of the head end fin and the free end of the tail end fin may be bent or curved in a direction away from the heat dissipation portion 20 to form a hook-shaped structure or an L-shaped structure, which further facilitates grasping and carrying by the mounting worker.

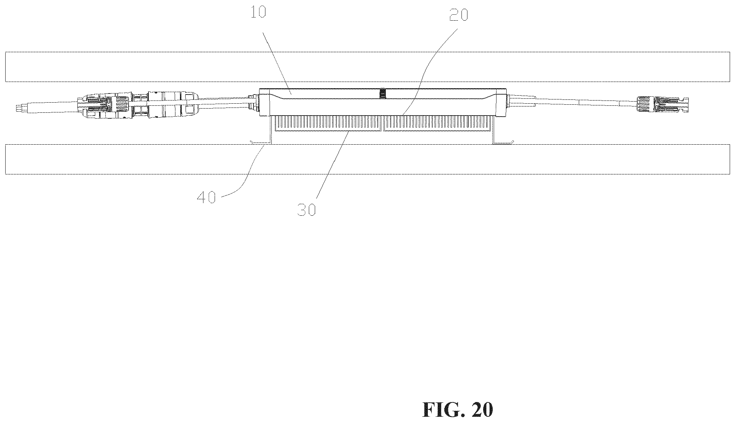

In a specific embodiment of the present application, referring to FIG. 20, the handle structure 40 protrudes, in a direction away from the body 10, with respect to free ends of the multiple fins except the head end fin and the tail end fin. In applications of household photovoltaic device, the power conversion device is arranged between a roof and a photovoltaic panel. The mounting space between the roof and the photovoltaic panel is relatively small, which is bad for heat exchange between the heat dissipation portion 20 and air. With the handle structure 40 being provided to protrude in the direction away from the body 10 with respect to free ends of the multiple fins except the head end fin and the tail end fin, the body 10 can be supported by the handle structure 40, such that an air flow channel is formed between the heat dissipation portion 20 and the roof, which improves the heat dissipation performance of the heat dissipation portion 20, and reduces the heat generated by the power conversion device during operation.

It should be noted that, terms used herein are only for describing specific embodiments, and are not intended to limit exemplary embodiments according to this application. As used herein, the singular form is intended to include the plural form, unless otherwise explicitly indicated in the context. In addition, it should be further understood that terms "include" and/or "comprise" used in this specification indicate that there are features, steps, operations, devices, assemblies, and/or combinations thereof.

Unless otherwise stated specifically, relative arrangements of the components and steps, the numerical expressions, and the values set forth in the embodiments are not intended to limit the scope of the present application. Meanwhile, it should be understood that, in order to facilitate description, sizes of respective parts shown in the accompanying drawings are not drawn according to an actual proportional relationship. Technologies, methods and devices known to those skilled in the art may not be discussed in detail, but such technologies, methods and devices should be considered as a part of the specification in appropriate situations. In all the examples shown and discussed herein, any specific value should be construed as merely illustrative and not as a limitation. Therefore, other examples of exemplary embodiments may have different values. It should be noted that, similar reference numerals and letters in the following drawings indicate similar items. Therefore, once an item is defined in a drawing, the item does not need to be further discussed in the subsequent drawings.

In the description of the present application, it should be noted that the orientation or positional relationships indicated by terms such as "front", "rear", "up", "down", "left", "right", "lateral", "vertical", "perpendicular", "horizontal", "top", "bottom", and the like are based on the orientation or positional relationships shown in the drawings, and are merely for the convenience of describing the present application and the simplification of the description. Unless otherwise stated to the contrary, these orientation terms do not indicate or imply that the device or element referred to must have a particular orientation, or be configured and operated in a particular orientation, which therefore should not be construed as a limitation to the protection scope of the present application. The orientation terms such as "inner", "outer" refer to the inside and outside with respect to the outline of each component itself.

For the convenience of description, spatially relative terms such as "on", "over", "on the upper surface of", "above" or the like can be used to describe the spatial positional relationship between a device or feature and another device or feature as shown in the drawings. It should be understood that spatially relative terms are intended to encompass different orientations in use or operation in addition to the orientation of the device depicted in the drawings. For example, if the devices in the drawings are inverted, devices described as "over another device or structures" or "on another device or structure" will be positioned as "under another device or structure" or "below another device or structure". Thus, the exemplary term "over" can include both positions of "over" and "below". The device can also be positioned in other different positions (rotated by 90 degrees or in other orientations), and the spatial relative description used herein is explained accordingly.

In addition, it should be noted that the terms "first" and "second" used to define parts are merely for the convenience of distinguishing the parts. Unless otherwise stated, the above terms have no special meaning, which therefore should not be construed as a limitation to the protection scope of the present application.

The above descriptions are merely preferred embodiments of the present application, and are not used to limit the scope of the present application. For those skilled in the art, various modifications and variations may be made to the present application. Any modifications, equivalent replacements and improvements made to the present application within the principle of the present application are deemed to fall into the protection scope of the present application.

## Claims

1. A power conversion device, comprising:
a body (10);
a heat dissipation portion (20), wherein the heat dissipation portion (20) is provided with a plurality of fins arranged spaced apart on the body (10), each of the plurality of fins comprises a connection end and a free end opposite to each other, and the fin is fixedly connected to the body (10) through the connection end; and
a shield sheet (30), being provided at a side of the heat dissipation portion (20) away from the body (10), wherein the shield sheet (30) shields a part of or all of free ends of the plurality of fins.

2. The power conversion device according to claim 1, wherein the plurality of fins comprises at least one supporting fin (22), and the shield sheet (30) is arranged at a free end of the at least one supporting fin (22).

3. The power conversion device according to claim 2, wherein the shield sheet (30) is connected to a free end of one of the at least one supporting fin (22), and the shield sheet (30) is located at one side or two sides of the one of the at least one supporting fin (22).

4. The power conversion device according to claim 3, wherein the heat dissipation portion (20) comprises a first end portion and a second end portion arranged opposite to each other in a direction along which the plurality of fins are distributed spaced apart, and wherein
the at least one supporting fin (22) is located at the first end portion and/or the second end portion; and/or
the at least one supporting fin (22) is located between the first end portion and the second end portion.

5. The power conversion device according to any one of claims 2 to 4, wherein the number of the at least one supporting fin (22) is plural, the shield sheet (30) is connected to the plurality of supporting fins (22), and at least one shield region is formed by connection between the shield sheet (30) and the plurality of supporting fins (22).

6. The power conversion device according to claim 5, wherein the plurality of fins further comprises at least one heat dissipation fin (21), the at least one heat dissipation fin (21) and the plurality of supporting fins (22) are arranged spaced apart, and at least one of the at least one heat dissipation fin (21) is located in the at least one shield region.

7. The power conversion device according to claim 2, wherein the plurality of fins further comprises at least one heat dissipation fin (21), and a gap is provided between a free end of the at least one heat dissipation fin (21) and the shield sheet (30).

8. The power conversion device according to claim 1, wherein a pierced structure is provided at the shield sheet (30), and the pierced structure is configured to avoid direct contact between a human hand and the plurality of fins.

9. The power conversion device according to claim 1, wherein in a direction along which the plurality of fins are distributed, a free end of a head end fin and a free end of a tail end fin extend in opposite directions away from each other, to respectively form a handle structure (40); and wherein the head end fin and the tail end fin are two outermost fins located at two ends of the heat dissipation portion (20) respectively.

10. The power conversion device according to claim 9, wherein the handle structure (40) protrudes with respect to free ends of the plurality of fins except the head end fin and the tail end fin.
